Europäisches Patentamt

European Patent Office

Office européen des brevets

(11) Numéro de publication : **0 446 112 A1**

# (12) DEMANDE DE BREVET EUROPEEN

(21) Numéro de dépôt : **91400573.1**

(22) Date de dépôt : **01.03.91**

(51) Int. Cl.⁵ : **H01L 23/538, H01L 23/498, H01L 21/48**

(30) Priorité : 06.03.90 FR 9002781

(43) Date de publication de la demande :
11.09.91 Bulletin 91/37

(84) Etats contractants désignés :
DE GB

(71) Demandeur : FRANCE TELECOM
6 place d'Alleray
F-75015 Paris (FR)

(72) Inventeur : Schiltz, André
4, Rue Champ Rochas
F-38240 Meylan (FR)
Inventeur : Bouzid, Marie-Jeanne
7, Rue Nicolas Chorier
F-38000 Grenoble (FR)

(74) Mandataire : Ramey, Daniel et al
Cabinet Ores 6 Avenue de Messine
F-75008 Paris (FR)

(54) Connecteur élastomérique pour circuits intégrés ou analogues, et son procédé de fabrication.

(57)  Connecteur élastomérique pour circuits intégrés ou analogues, comprenant un support (10) de matière élastomère sur une face (12) duquel est formé un réseau dense de lignes électro-conductrices (14). Des techniques de photogravure et de dépôt de métal sur une couche de matière décollable utilisées pour la fabrication des circuits intégrés, permettent de donner une très faible largeur et une conductivité très élevée aux lignes (14).

L'invention s'applique notamment à la connexion et aux tests des circuits intégrés et des circuits hybrides.

FIG.1

EP 0 446 112 A1

# CONNECTEUR ELASTOMERIQUE POUR CIRCUITS INTEGRES OU ANALOGUES, ET SON PROCEDE DE FABRICATION

L'invention concerne un connecteur élastomérique pour circuits intégrés ou analogues, ainsi que le procédé de fabrication d'un tel connecteur.

Il existe déjà des connecteurs électriques pour circuits intégrés ou analogues, qui comprennent un support en matière élastomère sur lequel sont formées des lignes électro-conductrices de faible largeur, permettant d'établir des liaisons électriques entre des conducteurs d'entrée/sortie de circuits intégrés, de circuits hybrides, de circuits de test, d'alimentation, de commande, etc... Il suffit pour cela que ces connecteurs soient positionnés correctement sur ou entre les circuits à réunir, et que leurs lignes conductrices soient appliquées à pression sur les conducteurs d'entrée/sortie de ces circuits.

Ces connecteurs présentent un certain nombre d'avantages par rapport à des connecteurs classiques: ils offrent une grande densité de lignes conductrices par unité de longueur, ils peuvent être utilisés dans une large gamme de températures, ils résistent aux chocs et aux vibrations, ils peuvent être montés et démontés un très grand nombre de fois sans détérioration, et ils résistent à de nombreux agents chimiques (les élastomères à base de silicone sont résistants en particulier à l'oxygène, à l'ozone et aux rayons ultraviolets). La nature souple du support en élastomère permet également de relier, moyennant une faible flexion de ce support, des circuits qui ne sont pas exactement au même niveau.

Les connecteurs connus de ce type présentent cependant quelques inconvénients :

– lorsque les lignes électro-conductrices sont formées par diffusion de carbone ou d'argent dans l'élastomère du support, elles ont une conductivité limitée, et une largeur d'au moins 25 micromètres;

– lorsque ces lignes électro-conductrices sont réalisées par laminage d'une grille conductrice (cuivre, or, etc...) sur le support en élastomère, elles ont une bonne conductivité, mais leur largeur est d'au moins 100 micromètres;

– ils ne présentent qu'un seul niveau de lignes conductrices;

– leurs procédés de fabrication peuvent être relativement complexes et onéreux, notamment lorsque ces connecteurs sont constitués d'un empilage de couches minces alternées respectivement conductrices et isolantes, qui peuvent avoir chacune une épaisseur de l'ordre de 50 micromètres.

L'invention a notamment pour but de pallier ces divers inconvénients des connecteurs antérieurs connus.

Elle a pour objet un connecteur électrique du type précité, comprenant un support en élastomère sur lequel sont formées des lignes électro-conductrices de faible largeur, dans lequel les lignes peuvent avoir une excellente conductivité électrique, avec des largeurs qui peuvent être réduites jusqu'au micromètre.

L'invention a encore pour objet un connecteur de ce type, qui présente des niveaux différents superposés de lignes électro-conductrices.

L'invention a également pour objet un connecteur de ce type, qui puisse être fabriqué par un procédé relativement simple et peu coûteux, faisant appel à des techniques éprouvées utilisées jusqu'à présent en microélectronique pour la fabrication de circuits intégrés et de circuits hybrides par exemple.

L'invention propose, à cet effet, un connecteur élastomérique pour circuits intégrés ou analogues, comprenant un support de matière élastomère sur lequel sont formées des lignes électro-conductrices de faible largeur, dont les extrémités sont destinées à être reliées par contact à pression à des conducteurs d'entrée et de sortie desdits circuits intégrés ou analogues, caractérisé en ce que ces lignes électro-conductrices sont des conducteurs métalliques pleins et continus, partiellement enterrés dans le support de matière élastomère et ayant des largeurs minimales de l'ordre du micromètre.

Les épaisseurs minimales de ces lignes électro-conductrices sont de quelques micromètres.

On peut donc obtenir un réseau extrêmement dense de lignes électro-conductrices, ayant une très faible résistivité du fait qu'elles sont constituées par des conducteurs métalliques pleins et continus tels que du cuivre ou de l'aluminium. Les connecteurs selon l'invention sont donc particulièrement bien adaptés à réaliser des ensembles de liaisons sur des circuits hybrides portant plusieurs circuits intégrés à grand nombre de conducteurs d'entrée/sortie.

Avantageusement, la matière élastomère du support est transparente, ce qui facilite un positionnement précis du connecteur par rapport à un circuit intégré ou à un circuit hybride.

Selon une autre caractéristique de l'invention, le connecteur comprend au moins deux niveaux superposés de lignes électro-conductrices, le niveau supérieur étant séparé du niveau inférieur par une épaisseur d'une matière polymère diélectrique, et les lignes électro-conductrices du niveau inférieur étant reliées à des lignes ou plages électro-conductrices du niveau supérieur par des plots de métal électro-conducteur traversant ladite épaisseur de matière polymère.

Cette superposition de niveaux de lignes électro-conductrices permet d'augmenter encore la densité des connexions sur le connecteur selon l'invention.

Bien entendu, la matière polymère interposée entre deux niveaux peut elle aussi être transparente, comme la matière élastomère du support, pour faciliter le positionnement du connecteur selon l'invention.

L'invention propose également un procédé de fabrication d'un connecteur de ce type, caractérisé en ce qu'il consiste à déposer sur une face du support une couche mince de matière décollable telle que du polysiloxanne, à former des canaux ou rainures par photogravure dans cette couche mince et dans la face sous-jacente du support, à déposer une couche mince de métal électroconducteur sur cette couche de matière décollable et dans les canaux ou rainures précités du support, puis à enlever du support ladite couche de matière décollable avec la couche de métal qui la recouvre, pour ne laisser le métal que dans les canaux ou rainures précités du support.

Le procédé selon l'invention permet de fixer avec précision les dimensions des lignes conductrices, aussi bien en largeur qu'en épaisseur, et de leur donner des dimensions très faibles si nécessaire, grâce à des techniques éprouvées appliquées jusque là à la fabrication de circuits électroniques intégrés.

Le procédé selon l'invention est donc fiable, précis et peu coûteux dans la mesure où il peut être exécuté au moyen d'installations existantes.

Plus précisément, le procédé selon l'invention consiste à déposer sur la couche de matière décollable une couche de résine photo-sensible, à exposer cette couche de résine à un rayonnement lumineux de nature appropriée à travers un masque, à développer ladite couche de résine, puis à graver ladite couche décollable et ensuite la face du support avant de déposer la couche mince de métal électro-conducteur.

Selon une autre caractéristique de l'invention, le procédé consiste à déposer initialement sur ladite face du support une couche mince intermédiaire de matière polymère, sur laquelle on dépose ensuite la couche mince de matière décollable, puis à graver cette couche mince intermédiaire en même temps que ladite face du support.

La présence de cette couche mince intermédiaire de matière polymère permet notamment de régler la hauteur des lignes conductrices par rapport à la face précitée du support de la matière élastomère.

On peut en effet, après dépôt de la couche de métal et enlèvement de la couche de matière décollable, soumettre cette couche intermédiaire à une opération supplémentaire de gravure pour réduire son épaisseur et régler ainsi la hauteur des lignes conductrices par rapport à la face précitée du support.

Selon encore une autre caractéristique de l'invention, le procédé consiste ensuite à recouvrir la face du support sur laquelle sont formées les lignes électro-conductrices, par une couche mince de matière polymère, à former de la façon précitée par gravure et dépôt de métal, des plots électro-conducteurs traversant cette couche mince et reliés aux lignes électro-conductrices précitées, à déposer ensuite une nouvelle couche mince de matière polymère, et à former dans celle-ci par gravure et dépôt de métal de la façon précitée, une nouvelle série de lignes et de plages électro-conductrices, dont certaines sont reliées aux plots précités.

On réalise ainsi, de façon simple, un connecteur à deux niveaux de lignes électro-conductrices. En répétant les opérations précitées, on obtient un connecteur à plusieurs niveaux superposés de lignes électro-conductrices.

L'invention sera mieux comprise et d'autres caractéristiques, détails et avantages de celle-ci apparaîtront plus clairement à la lecture de la description qui suit, faite à titre d'exemple en référence aux dessins annexés dans lesquels :

la figure 1 est une vue schématique partielle d'un connecteur selon l'invention ;

la figure 2 est une vue schématique partielle d'une variante de réalisation de ce connecteur ;

les figures 3a à 3g illustrent schématiquement les principales étapes d'un procédé de fabrication d'un connecteur selon l'invention ;

les figures 4a à 4e illustrent schématiquement les principales étapes d'une variante de ce procédé.

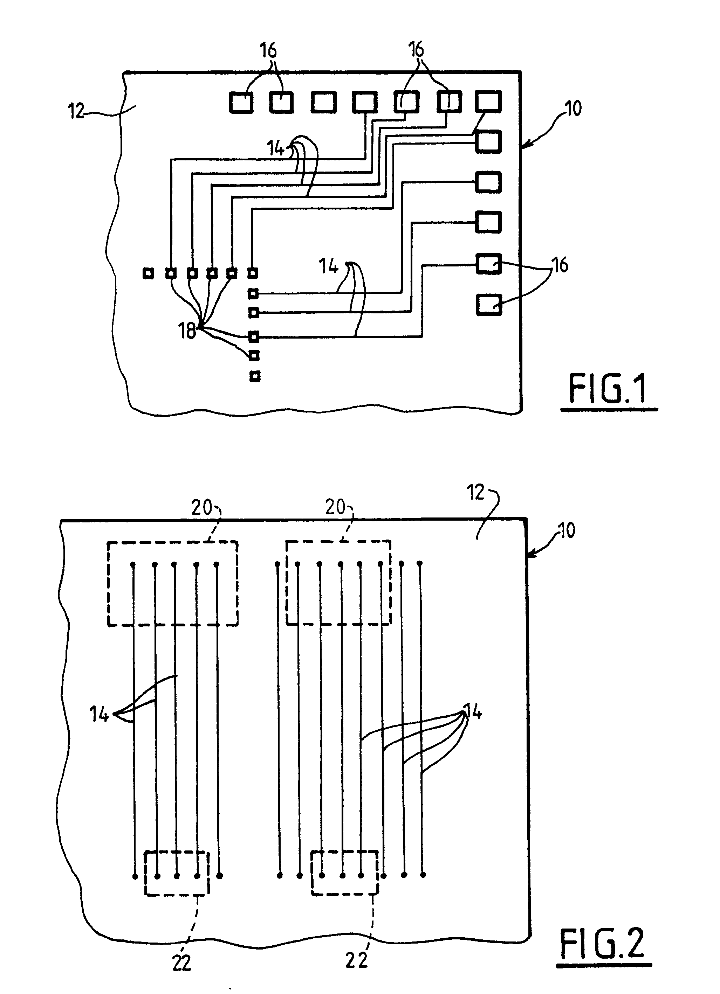

On se réfère d'abord aux figures 1 et 2, dans lesquelles on a représenté schématiquement deux formes de réalisation possible d'un connecteur selon l'invention.

Le connecteur de la figure 1 comprend un support 10 de matière élastomère, pouvant avoir une épaisseur de l'ordre de 2 mm par exemple, sur une face 12 duquel sont formées des lignes électro-conductrices 14 reliant entre elles deux à deux des plages de contact 16, 18 dont les unes sont formées le long des bords du support 10 et les autres le long des côtés d'un emplacement d'un circuit hybride ou d'un circuit intégré.

Selon l'invention, les lignes électro-conductrices 14 peuvent avoir une largeur aussi faible qu'un micromètre et une épaisseur de l'ordre de quelques micromètres. En pratique, la largeur des lignes 14 peut avoir toute valeur souhaitée en fonction de l'utilisation envisagée, par exemple une largeur de 5, 10, 25, 50 ou 100 micromètres.

Comme ces lignes électro-conductrices 14 sont formées par des conducteurs métalliques pleins et continus, par exemple de cuivre, d'aluminium, d'argent ou d'or, elles ont une conductivité très élevée.

Le connecteur selon l'invention, représenté schématiquement en figure 2, comprend lui aussi un support 10 en matière élastomère, sur une face 12 duquel sont formées des séries de lignes 14 électro-conductrices destinées à relier entre eux des conducteurs 20, 22 représentés en pointillés, dont les uns sont formés sur une carte de test par exemple, et dont les autres sont des conducteurs d'entrée/sortie d'un circuit hybride ou d'un circuit intégré.

Comme les lignes électro-conductrices 14 ont une largeur qui peut être très inférieure à celle des conducteurs 20, 22, on peut prévoir plusieurs lignes 14 par couple de conducteurs 20, 22 et réaliser ainsi des connexions redondantes entre ces conducteurs, ce qui permet un positionnement plus facile du connecteur sur les composants à relier. En outre, la redondance des connexions est une garantie d'établissement des liaisons électriques voulues.

Le support 10 de matière élastomère peut être en caoutchouc fluoré, non transparent, ou en élastomère à base de silicone (transparent) pour faciliter le positionnement précis du connecteur.

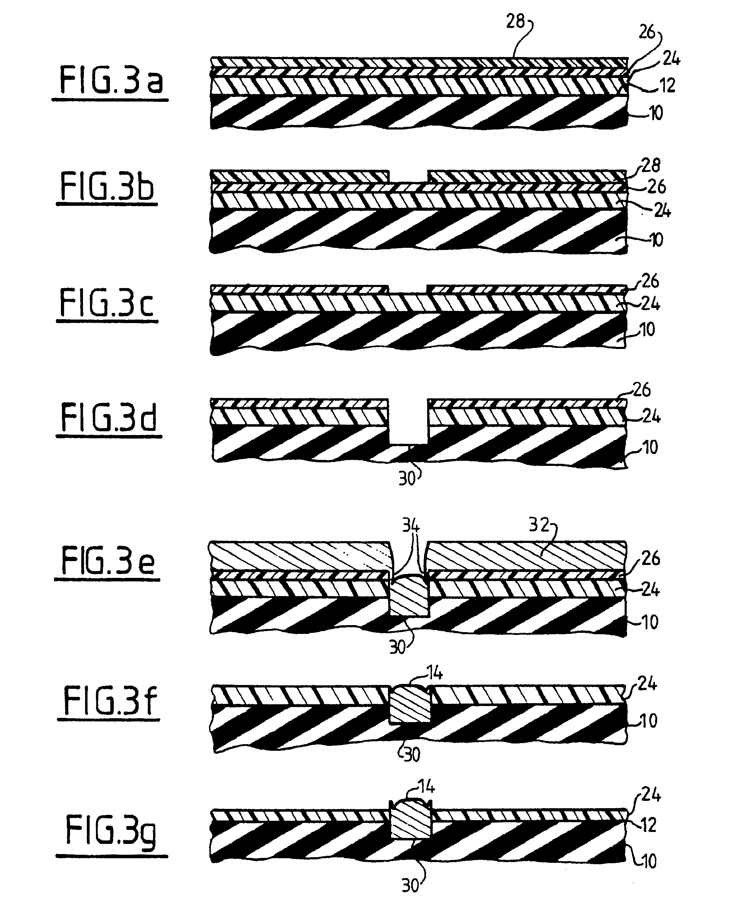

On se référera maintenant aux figures 3a à 3g, qui représentent schématiquement les étapes essentielles d'un procédé de fabrication d'un connecteur selon l'invention.

En figure 3a, la référence 10 désigne, comme dans les figures 1 et 2, le support de matière élastomère, dont la face 12 est recouverte d'une couche mince intermédiaire 24 de matière polymère (par exemple de résine époxyde transparente). Cette couche 24 est elle-même recouverte d'une couche mince 26 de matière décollable (communément appelée couche de lift-off) tel que du polysiloxane par exemple.

Sur cette couche 26 est enfin déposée une couche mince 28 d'une résine photo-sensible.

Le support 10 de matière élastomère peut avoir une épaisseur de 2 mm environ, tandis que la couche intermédiaire 24 a une épaisseur de 2 à 3 μm environ, la couche 26 de matière décollable une épaisseur de 0,3 à 0,5 μm environ, et la couche 28 de résine photo-sensible une épaisseur de 1 à 1,5 μm.

La première étape du procédé selon l'invention consiste à soumettre cette couche 28 de résine photo-sensible à une insolation, par exposition à un rayonnement lumineux approprié, par exemple un rayonnement ultraviolet, à travers un masque définissant le réseau des lignes électro-conductrices 14 à former sur la face 12 du support 10. Cette insolation de la résine photo-sensible est suivie d'une opération de développement de la résine, pour arriver à la structure représentée en figure 3b.

Le procédé selon l'invention consiste ensuite à graver le réseau de lignes électro-conductrices 14 dans la couche 26 de matière décollable (figure 3c) au moyen d'un plasma d'hexafluorure de soufre (SF6), puis dans la couche intermédiaire 24 et le support 10 (figure 3d) au moyen d'un plasma riche en oxygène.

Cette gravure permet de former des rainures ou canaux 30 dans la face 12 du support 10, dans lesquels seront enterrées partiellement les lignes électro-conductrices 14.

Les étapes suivantes du procédé selon l'invention consistent (figure 3e) à déposer une couche mince 32 du métal choisi sur le support ainsi préparé, c'est-à-dire à l'intérieur des rainures ou canaux 30 et sur la couche 26 de matière décollable. L'épaisseur de la couche de métal 32 est par exemple supérieure ou égale à 5 μm environ, de façon à remplir les canaux ou rainures 30 sur une hauteur correspondant à peu près au niveau de la face supérieure de la couche intermédiaire 24.

Le métal est déposé par toute technique appropriée, par exemple par évaporation, ou par pulvérisation, ou encore par pulvérisation en couche mince avec épaississement de la couche par croissance électro-chimique, soit encore par dépôt de vapeur chimique (Chemical Vapor Déposition).

Bien entendu, la matière élastomère du support 10 et la matière polymère de la couche intermédiaire 24 sont choisies de manière à résister aux températures de dépôt du métal, c'est-à-dire à des températures de l'ordre de 150 à 250°C.

L'étape suivante du procédé est représentée en figure 3f et consiste à enlever la couche 26 de matière décollable, ainsi que la couche de métal 32 qui la recouvre. On peut procéder pour cela par voie mécanique (trempage dans de l'azote liquide, provoquant un délaminage de la couche 26 par dilatation thermique différentielle entre cette couche d'une part, et la couche intermédiaire 24 et le support 10 d'autre part) ou par voie chimique ( au moyen d'une solution d'acide fluorhydrique diluée qui attaque la matière de la couche 26).

Eventuellement, on peut effectuer au préalable une gravure chimique limitée de la couche de métal, pour rompre les ponts 34 de faible épaisseur qui relient le métal remplissant les canaux ou rainures 30 et la couche de métal 32 formée sur la couche 26 de matière décollable.

Le métal qui remplit les canaux ou rainures 30 forme ainsi les lignes électro-conductrices 14 précitées.

La hauteur de ces lignes 14 par rapport à la face 12 du support 10 peut être réglée par une gravure supplémentaire de la couche intermédiaire 24, permettant de réduire son épaisseur, au moyen d'un plasma riche en oxygène. Eventuellement, toute la matière de la couche 24 peut être éliminée.

Le procédé représenté dans les figures 3d à 3g permet donc d'obtenir un connecteur tel que celui représenté en figure 1 ou en figure 2, à un seul niveau de lignes électro-conductrices. On comprend cependant qu'en répétant ce procédé, on peut obtenir un connecteur à plusieurs niveaux superposés de lignes conductrices.

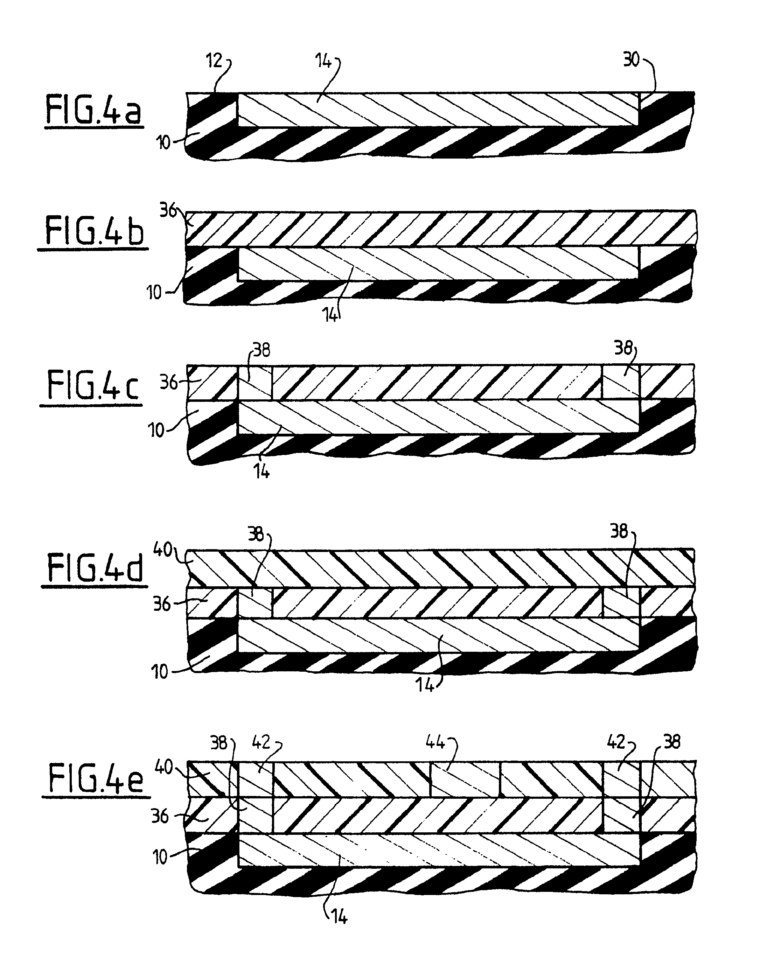

On peut pour cela procéder de la façon représentée schématiquement dans les figures 4a à 4e.

En figure 4a, on a représenté un support 10 de matière élastomère, dont une face 12 comprend un réseau de lignes électro-conductrices 14, formées de conducteurs métalliques pleins et continus qui sont enterrés dans le support 10, c'est-à-dire que la face supérieure des lignes électro-conductrices 14 est sensiblement au niveau de la face supérieure 12 du support 10.

Ces lignes électro-conductrices 14 ont été formées sur le support 10 au moyen du procédé qui vient d'être décrit en référence aux figures 3a à 3g, la hauteur des canaux ou rainures 30 recevant les lignes électro-conductrices 14 et 30 étant toutefois calculée pour que ces lignes 14 ne fassent sensiblement pas saillie au-dessus du support 10.

L'étape suivante du procédé, représentée en figure 4b, consiste à déposer sur le support 10 une couche mince 36 de matière polymère, par exemple de la matière utilisée pour la couche mince intermédiaire 24 précitée. Cette couche 36 peut avoir une épaisseur de 5 μm environ, par exemple. Les étapes suivantes du procédé consistent à former dans cette couche 36 des plots métalliques conducteurs qui sont reliés aux lignes électro-conductrices 14 et qui s'étendent sur toute l'épaisseur de la couche 36, pour déboucher sur la face supérieure de celle-ci. Cette gravure de la couche 36 et le dépôt de métal formant les plots 38 sont réalisés par les étapes de procédé représentées en figures 3a à 3f.

L'étape suivante, représentée en figure 4d, consiste à déposer une nouvelle couche 40 de matière polymère sur la couche 36 précitée et les plots de liaison 38. La matière polymère de la couche 40 peut bien entendu être la même que celle de la couche 36.

On répète ensuite les opérations précitées de gravure et de dépôt de métal pour former dans cette couche 40, d'une part des lignes ou plages de contact 42 qui sont reliées aux plots de contact 38 précités, et d'autre part un autre réseau de lignes électro-conductrices 44 dont au moins certaines vont croiser les lignes 14 du niveau inférieur, tout en étant séparées de celles-ci par la couche de matière polymère 36.

Une opération finale de gravure au plasma riche en oxygène permet de réduire l'épaisseur de la couche 40 pour faire émerger partiellement les plages et les lignes 42, 44.

On obtient ainsi un connecteur électrique à deux niveaux de lignes conductrices 14, 44.

En répétant les étapes des figures 4b à 4e, on peut bien entendu réaliser un connecteur à plusieurs niveaux superposés de lignes conductrices qui se croisent.

Un tel connecteur est utile notamment lorsque le nombre de points à relier est très élevé et/ou lorsqu'un croisement des lignes d'interconnexion est inévitable, par exemple dans le cas de circuits dont les points de contact sont distribués sur une surface entière, ou sur des surfaces concentriques.

De façon générale, les avantages de l'invention sont les suivants :

– les lignes électro-conductrices de connexion peuvent être très fines (largeur supérieure ou égale à 1 μm) avec un pas très faible (supérieur ou égal à 5 ou 10 μm)

– ces lignes électro-conductrices ont une conductivité très élevée

– on peut former plusieurs niveaux superposés de connexions

– le procédé de fabrication est fiable et utilise des techniques et des moyens éprouvés dans la fabrication des circuit intégrés

– il est en général plus rapide et moins coûteux que les procédés de fabrication des connecteurs comparables de la technique antérieure.

– le connecteur selon l'invention est utilisable aussi bien pour des connexions à des circuits à grand nombre d'entrées/sorties, que pour des tests de ces circuits, les contacts entre les conducteurs du connecteur et ceux des circuits étant établis par pression mécanique.

## Revendications

1. Connecteur élastomérique pour circuits intégrés ou analogues, comprenant un support (10) de matière élastomère sur lequel sont formées des lignes électro-conductrices (14) de faible largeur, dont les extrémités sont destinées à être reliées par contact à pression à des conducteurs d'entrée et de sortie desdits circuits intégrés ou analogues, caractérisé en ce que ces lignes électro-conductrices sont des conducteurs métalliques pleins et continus partiellement enterrés dans le support (10) de matière élastomère et ayant des largeurs minimales de l'ordre du micromètre.

2. Connecteur selon la revendication 1, caractérisé en ce que les épaisseurs minimales des lignes électro-conductrices sont de quelques micromètres.

3. Connecteur selon la revendication 1 ou 2, caractérisé en ce que le pas minimal des lignes électro-conductrices (14) est de quelques micromètres.

4. Connecteur selon l'une des revendications précédentes, caractérisé en ce que la matière élastomère du support (10) est transparente.

5. Connecteur selon l'une des revendications précédentes, caractérisé en ce qu'il comprend au moins deux niveaux superposés de lignes conductrices (14, 44), le niveau supérieur étant séparé du niveau inférieur par une épaisseur (36) d'une matière polymère diélectrique, les lignes électro-conductrices (14) du niveau inférieur étant reliées à des lignes ou plages électro-conductrices (42) du niveau supérieur par des plots (38) de métal électro-conducteur traversant ladite épaisseur (36) de la matière polymère.

6. Connecteur selon la revendication 5, caractérisé en ce que ladite matière polymère (36) est transparente.

7. Procédé de fabrication d'un connecteur élastomérique pour circuits intégrés ou analogues, comprenant un support (10) de matière élastomère sur lequel sont formées des lignes électro-conductrices (14) de faible largeur, caractérisé en ce qu'il consiste à déposer sur une face (12) du support une couche mince (26) de matière décollable telle que du polysiloxanne, à former des canaux ou rainures (30) par photogravure dans cette couche mince (26) et dans la face (12) sous-jacente du support, à déposer une couche mince (32) de métal électro-conducteur sur cette couche de matière décollable (26) et dans les canaux ou rainures précités du support (10), puis en enlever du support ladite couche de matière décollable (26) avec la couche de métal qui la recouvre, pour ne laisser le métal que dans les canaux ou rainures (30) précités du support.

8. Procédé selon la revendication 7, caractérisé en ce que, pour la photogravure, il consiste à déposer sur la couche (26) de matière décollable une couche (28) de résine photosensible, à exposer cette couche de résine à un rayonnement lumineux de nature appropriée à travers un masque, à développer ladite couche de résine (28), puis à graver ladite couche (26) de matière décollable et ensuite la face (12) du support (10) avant de déposer la couche mince (32) de métal électro-conducteur.

9. Procédé selon la revendication 7 ou 8, caractérisé en ce qu'il consiste à déposer initialement sur la face (12) du support une couche mince intermédiaire (24) de matière polymère sur laquelle on dépose ensuite la couche mince de matière décollable (26), puis à graver cette couche mince intermédiaire (24) en même temps que la face (12) du support (10).

10. Procédé selon la revendication 9, caractérisé en ce que, après dépôt de la couche (32) de métal et enlèvement de la couche de matière décollable (26), on soumet ladite couche intermédiaire (24) à une opération supplémentaire de gravure pour réduire son épaisseur.

11. Procédé selon l'une des revendications 7 à 10, caractérisé en ce qu'il consiste ensuite à recouvrir ladite face du support (10) sur laquelle sont formées les lignes électro-conductrices (14), d'une couche mince (36) de matière polymère, à former, de la façon précitée par gravure et dépôt de métal, des plots électro-conducteurs (38) traversant cette couche mince et reliés aux lignes électro-conductrices (14) précitées, à déposer ensuite une nouvelle couche mince (40) de matière polymère, et à former dans celle-ci, par gravure et dépôt de métal de la façon précitée, une nouvelle série de lignes et de plages électro-conductrices (42, 44) dont certaines sont reliées aux plots précités (38).

FIG.1

FIG.2

FIG.3a

FIG.3b

FIG.3c

FIG.3d

FIG.3e

FIG.3f

FIG.3g

FIG.4a

12  14  30
10

FIG.4b

36
10  14

FIG.4c

38  38
36
10  14

FIG.4d

40  38  38
36
10  14

FIG.4e

38  42  44  42  38
40
36
10  14

EP 0 446 112 A1

**Office européen des brevets**

## RAPPORT DE RECHERCHE EUROPEENNE

Numero de la demande

EP 91 40 0573

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | EP-A-0 310 357 (MICROELECTRONICS AND COMPUTER TECHNOLOGY)<br>* Revendications 1,11; colonne 13, lignes 48-60 * | 1 | H 01 L 23/538<br>H 01 L 23/498<br>H 01 L 21/48 |
| A | --- | 3,5,7 | |
| A | WO-A-8 912 911 (UNISTRUCTURE)<br>* Revendications 1,2,17; page 2, lignes 9-13 * | 1,2,7 | |
| A | --- <br>EP-A-0 072 673 (MINNESOTA MINING)<br>* Revendications 1,8,9; page 7, lignes 7-24 * | 1,2,5,7 | |
| A | --- <br>US-A-4 681 654 (IBM)<br>* Figure 6; colonne 9, ligne 58 - colonne 10, ligne 10; revendications 1,8 * | 1,2,5,7 | |
| A | --- <br>DE-A-3 616 493 (TEKTRONIX)<br>* Revendications 1,6,9; figure 1 *<br>----- | 1,4-6 | DOMAINES TECHNIQUES RECHERCHES (Int. Cl.5)<br><br>H 01 L |

Le présent rapport a été établi pour toutes les revendications

| Lieu de la recherche | Date d'achèvement de la recherche | Examinateur |
|---|---|---|
| LA HAYE | 07-05-1991 | DE RAEVE R.A.L. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

&: membre de la même famille, document correspondant

EPO FORM 1503 03.82 (P0402)